# FASCICULE DE BREVET EUROPEEN

(11) **EP 0 756 331 B1**
(45) Date de publication et mention de la délivrance du brevet: **15.12.1999**
(21) Numéro de dépôt: 96420258.4
(22) Date de dépôt: 26.07.1996
(51) Int. Cl.: H01L 29/87

(54) **Composant limiteur de courant et procédé de réalisation**
Stormbegrenzungsanordnung und Verfahren zur Herstellung
Current limiting component and method for making the same

(30) Priorité: 28.07.1995 FR 9509442
(43) Date de publication de la demande: 29.01.1997
(73) Titulaire: FERRAZ Société Anonyme, F-69003 Lyon (FR); CENTRO NACIONAL DE MICROELECTRONICA - CSIC, 08193 Bellatera (ES)
(72) Inventeur: Godignon, Philippe, 08015 Barcelona (ES); De Palma, Jean-François, 69120 Vaulx en Velin (FR); Deshayes, René, 69800 Saint Priest (FR); Fernandez, Juan, 08191 Rubi (ES); Millan, José, 08208 Sabadell (ES)
(74) Mandataire: Myon, Gérard Jean-Pierre

(56) Documents cités:
- EP-A- 0 021 899
- EP-A- 0 347 778
- WO-A-91/04579
- FR-A- 1 565 551

## Description

La présente invention concerne un composant limiteur de courant, destiné donc à être branché en série sur la branche de circuit pour laquelle on souhaite une limitation de courant.

En matière de composants limiteurs de courant, ou limiteurs de surintensité, on connaît les Résistances de Coefficient Positif, ou "PTC", qui sont des composants polymères aptes à supporter de fortes intensités. Leur temps de réaction à une surintensité est cependant trop lent pour qu'ils puissent être utilisés pour certaines applications où la réaction de limitation doit être très rapide.

On connaît des composants limiteurs de courant, du type semi-conducteur à structure MOS, qui réagissent rapidement mais qui ne peuvent pas supporter des intensités nominales élevées, par exemple de l'ordre de quelques dizaines d'Ampères comme il est souvent souhaité.

L'invention, qui vise à remédier à ces inconvénients de ces composants connus, propose un composant limiteur de surintensité qui est apte à supporter un courant nominal de plusieurs dizaines d'Ampères, et qui réagit très rapidement à une surintensité accidentelle, son temps de réaction étant par exemple de l'ordre de la microseconde.

Elle se rapporte en conséquence à un composant limiteur de courant, du type "quatre couches", qui est constitué d'une tranche ou barre de semi-conducteur à trois jonctions, ce semi-conducteur étant compris entre deux électrodes, dont une électrode, ou anode, d'entrée du courant à limiter et une électrode, ou cathode, de sortie de ce courant, et comportant successivement, entre cette anode et cette cathode :
- une première zone, dopée P
- une deuxième zone, dopée N
- une troisième zone, dopée P
- et une quatrième et dernière zone, dopée N,
dans lequel
la barre ou tranche de semi-conducteur, tel que du Silicium, utilisée pour la réalisation de ce composant a une longueur (ou "épaisseur") comprise entre 160 et 700 microns et un dopage de base compris entre 10¹³cm⁻³ et 10¹⁵cm⁻³,
ladite première zone est dopée P à plus de 10¹⁸ atomes/cm⁻³ avec une diffusion relativement peu profonde, de profondeur typiquement comprise entre 0,5 et 5 microns,
ladite quatrième zone est dopée N à plus de 10¹⁸ atomes/cm⁻³ avec une diffusion elle-aussi relativement peu profonde, de profondeur typiquement comprise entre 0,2 et 2 microns,
lesdites deuxième et troisième zones sont respectivement dopées N à moins de 10¹⁵ atomes/cm⁻³, et P à une valeur comprise entre 10¹⁷ et 10¹⁹ atomes/cm⁻³, avec une diffusion bien plus profonde, de profondeur typiquement variant de 5 à 90 microns lorsque les profondeurs des première et quatrième zones varient de respectivement de 0,5 à 5 microns et de 0,2 à 2 microns,
les caractéristiques dimensionnelles et les caractéristiques de dopage de cette barre de semi-conducteur étant choisies pour que :
. la caractéristique courant-tension de ce composant soit, en direct, celle d'une diode pour toutes les valeurs d'intensité du courant n'excédant par une valeur limite IL ; et
. pour cette valeur limite IL, cette caractéristique présente un palier, le courant restant alors sensiblement constant et égal à cette valeur limite IL tandis que la tension aux bornes de ce composant croît, jusqu'à bien entendu une valeur limite de tension VBR qui correspond à la tension de claquage du composant.

Avantageusement, les caractéristiques de dopage respectives de ces quatre zones successives N,P,N,P sont telles que, pour les faibles niveaux de courant, la somme des gains en courant du transistor bipolaire PNP formé par les trois premières zones et du transistor bipolaire NPN formé par les trois dernières zones soit égale à 1.

De toute façon, l'invention sera bien comprise, et ses avantages et caractéristiques ressortiront mieux, lors de la description suivante d'un exemple de réalisation de ce composant, en référence au dessin schématique annexé, dans lequel :
- Figure 1 représente schématiquement ce composant, avec ses différentes couches
- Figure 2 est sa caractéristique de réponse courants-tensions
- Figure 3 est son schéma électrique équivalent

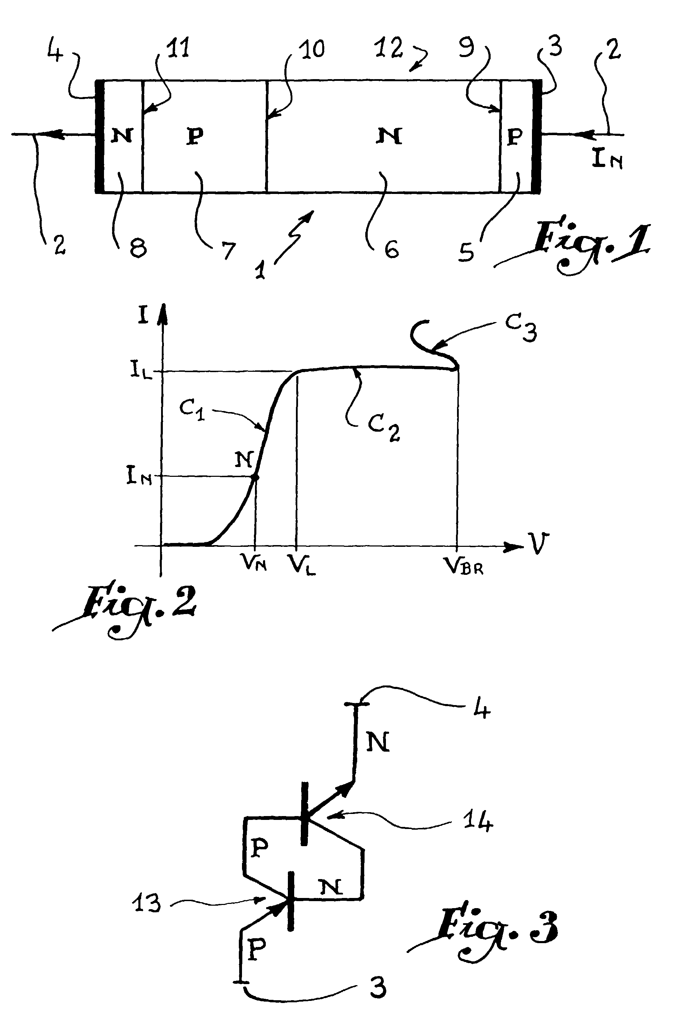

En se reportant à la figure 1, le composant limiteur de l'invention 1 est représenté branché en série sur une ligne électrique 2 qui est parcourue par un courant électrique unidirectionnel dont l'intensité nomimane IN est par exemple de 50 Ampères.

Ce composant 1 est muni de deux électrodes, une anode 3 et une cathode 4, qui permettent classiquement de le brancher en série sur la ligne électrique 2.

Le composant lui-même est constitué d'une tranche ou barre 12 de matériau semi-conducteur, typiquement du Silicium, qui est dopé comme représenté de manière à définir 4 zones ou couches successives, soit, de l'anode 3 à la cathode 4 :
. une première couche 5, dopée P,
. une deuxième couche 6, dopée N,
. une troisième couche 7, dopée P,
. une quatrième couche 8, dopée N.

Ces quatre couches successives définissent trois jonctions 9, 10 et 11.

Conformément à l'invention, les caractéristiques dimensionnelles et les caractéristiques de dopage de la barre de Silicium 12 sont choisies pour que, contrairement à un autre composant connu - le thyristor - qui est aussi un composant à quatre couches :
. la caractéristique courant-tension de ce composant soit, en direct, celle d'une diode pour toutes les valeurs d'intensité du courant n'excédant pas une valeur limite IL ; et
. pour cette valeur limite IL, cette caractéristique présente un palier, le courant restant sensiblement constant et sensiblement égal à cette valeur limite IL tandis que la tension aux bornes de ce composant croît, jusqu'à bien entendu une valeur limite de tension VBR qui correspond à la tension de claquage en limiteur du composant.

La caractéristique "courant (I) - tension (V)" qui est finalement obtenue en choisissant de telles caractéristiques dimensionnelles et de dopages pour le barreau de Silicium 12 est celle représentée en Figure 2.

Il s'agit là uniquement de la caractéristique en direct car, contrairement au thyristor, ce composant ne tient pas la tension inverse et ne peut donc pas fonctionner en redresseur.

Comme on le voit sur la figure 2, tant que le courant I qui traverse le composant 1 reste inférieur à une valeur limite IL, la caractéristique I(V) est celle d'une diode alimentée en direct, ou C1, la chute de tension V aux bornes du composant restant donc très faible comme c'est le cas pour une diode polarisée en direct.

On a marqué sur la courbe le point N de fonctionnement nominal, pour lequel le courant I est le courant nominal IN, par exemple 5 Ampères, tandis que la chute de tension VN aux bornes du composant est inférieure à 1 Volt.

Pour une valeur limite de courant IL, égale par exemple à 6 à 10 fois le courant nominal IN, la courbe I(V) s'infléchit brusquement pour devenir un palier C3 à courant sensiblement constant et égal à IL : le composant 1 fonctionne alors en limiteur de courant, alors que la tension V à ses bornes peut alors croître régulièrement.

Bien entendu, cette croissance de la tension V n'est possible que jusqu'à la tension de claquage en limiteur VBR du composant 1, à partir de laquelle se produit le classique phénomène d'avalanche (partie C3 de la courbe) qui conduit à la destruction du composant.

A noter que le palier C2 est dû à un phénomène de désaturation déjà mentionné pour certains auteurs. Ce phénomène est, dans le domaine des thyristors, un phénomène parasite, et ces derniers sont donc réalisés de manière à l'éviter, contrairement à l'invention où ce phénomène est, bien au contraire, avantageusement exploité.

Un schéma équivalent du composant 1 est représenté sur la figure 3, où les couches 5,6,7 définissent un transistor 13 de type PNP, tandis que les couches 6,7,8 définissent un autre transistor 14, de type NPN. Ce schéma équivalent n'est qu'approximatif, puisque le composant 1 ne tient pas la tension inverse, ce qui ne serait pas nécessairement le cas d'un circuit disposé selon la figure 3.

Pour obtenir un composant limiteur 1 qui fonctionne selon la caractéristique de la figure 2, il est bien entendu nécessaire d'ajuster certains paramètres technologiques, sans quoi on courrait le risque non seulement d'obtenir un composant qui ne fonctionnerait pas comme un limiteur de courant, mais encore d'obtenir un thyristor, c'est-à-dire un redresseur qui aurait besoin d'être déclenché au moyen d'une source auxiliaire pour devenir conducteur :
- La tension de claquage VBR dépend essentiellement des propriétés initiales de la barre de Silicium 12, ou substrat, avant création par dopage des trois jonctions 9, 10 et 11 des valeurs de dopage initial de ce substrat qui sont comprises entre 10¹³ cm⁻³ et 10¹⁵ cm⁻³, et des longueurs (ou "épaisseurs") de la barre 12 comprises entre 160 et 700 microns, ont été trouvées adéquates pour la mise en oeuvre de l'invention.
- La première zone 5 est dopée P à plus de 10¹⁸ atomes/cm⁻³, avec une diffusion relativement peu profonde, de profondeur typiquement comprise entre 0,5 et 5 microns. La quatrième zone 8 est dopée N à plus de 10¹⁸ atomes/cm⁻³, avec une diffusion elle-aussi relativement peu profonde, de profondeur typiquement comprise entre 0,2 et 2 microns. La deuxième zone 6 est dopée N à moins de 10¹⁵ atomes/cm⁻³, tandis que la troisième zone est dopée P à une valeur comprise entre 10¹⁷ et 10¹⁹ atomes/cm⁻³, toutes deux avec une diffusion bien plus profonde, de profondeur variant de 5 à 90 microns lorsque les profondeurs des première et quatrième zone 5,8 varient respectivement de 0,5 à 5 microns et de 0,2 à 2 microns.

En ajustant ces caractéristiques dans ces gammes de valeurs, il a été possible d'obtenir la caractéristique de diode C1, suivie du palier à courant constant C2.

Il a été trouvé que ce résultat peut être obtenu, en ce qui concerne les première et quatrième zone 5,8, ou "émetteurs", soit en utilisant un procédé de dopage par implantation + diffusion, avec des doses d'implantation comprises entre 7.10¹⁴ et 7.10¹⁵ cm⁻² et des temps de diffusion compris entre 20 et 70 minutes en ambiance neutre ou oxydante, soit par diffusion en phase solide, liquide ou gazeuse pour obtenir des niveaux de dopage compris entre 5.10¹⁹ cm⁻³ et 5.10²⁰ cm⁻³ pour la quatrième zone 8 dopée N, et entre 8.10¹⁸ cm⁻³ et 8.10¹⁹ cm⁻³ pour la première zone 5, dopée P, avec des profondeurs de jonctions allant de 0,2 à 2 microns pour la quatrième zone 8 et de 0,5 à 5 microns pour la première zone 5.

De même façon, la troisième zone, ou "base", 7, peut être dopée P soit par un procédé d'implantation + diffusion d'impuretés de type P, soit par un procédé de diffusion en phase solide, liquide, ou gazeuse.
- La somme des gains en courant des transistors 14 et 15 (Figure 3) doit être égale à 1 à faible courant.

La technologie de fabrication de ce limiteur de courant 1 peut être soit une technologie "planare" soit une technologie "mésa".

Dans ce qui précède, plusieurs fourchettes de valeurs de dopages et profondeurs sont données. Toutefois, il faut bien noter que seules certaines combinaisons entre valeurs des différentes fourchettes permettent d'obtenir la caractéristique voulue. On peut considérer qu'il y a 8 paramètres interdépendants. Il semble donc impossible de répertorier toutes les possibilités sauf si l'on considère les fourchettes entières et que l'on considère que dans ces fourchettes, seules certaines combinaisons fonctionnent.

Pour bien voir comment fonctionne l'optimisation du composant, prenons un exemple :
- Fixons: épaisseur substrat 12 = 320 microns et dopage 10¹⁴ cm⁻³
dose zone 7 = 8x10¹⁴ cm⁻² et temps de recuit 2000 heures à 1200°C
dopage émetteur 5 = 5x10¹⁹ cm⁻³ et profondeur 2 microns
temps de recuit de l'émetteur 4 = 30 minutes

Ces sept paramètres (ou groupes de paramètres) étant fixés, on peut alors fixer une fourchette pour le dopage de l'émetteur (huitième paramètre) : 9,2x10¹⁹ à 1,2x10²⁰ cm⁻³.

Si l'on change l'un des 7 autres paramètres, cette fourchette n'est plus valable.

De plus, il y a un neuvième paramètre qui va influencer les caractéristiques : la durée de vie des porteurs. Cette durée de vie n'est pas constante dans la structure et il est possible que le composant fonctionne pour une distribution de durée de vie et qu'il ne fonctionne pas pour une autre distribution (cette distribution dépendant notamment des conditions de fabrication).

## Revendications

1. Composant limiteur de courant, constitué d'une tranche ou barre (12) de semi-conducteur à trois jonctions (9,10,11), ce demi-conducteur étant compris entre deux électrodes (3,4), dont une électrode, ou anode (3), d'entrée du courant à limiter et une électrode, ou cathode (4), de sortie de ce courant, et comportant successivement, entre cette anode et cette cathode :
- une première zone (5), dopée P
- une deuxième zone (6), dopée N
- une troisième zone (7), dopée P
- une quatrième et dernière zone (8), dopée N,
dans lequel
la tranche (12) de semi-conducteur, tel que du Silicium, utilisée pour la réalisation de ce composant a une longueur (ou "épaisseur") comprise entre 160 et 700 microns et un dopage de base compris entre 10¹³cm⁻³ et 10¹⁵cm⁻³,
ladite première zone (5) est dopée P à plus de 10¹⁸ atomes/cm⁻³ avec une diffusion relativement peu profonde, de profondeur typiquement comprise entre 0,5 et 5 microns,
ladite quatrième zone (8) est dopée N à plus de 10¹⁸ atomes/cm⁻³ avec une diffusion elle-aussi relativement peu profonde, de profondeur typiquement comprise entre 0,2 et 2 microns,
lesdites deuxième (6) et troisième (7) zones sont respectivement dopées N à moins de 10¹⁵ atomes/cm⁻³, et P à une valeur comprise entre 10¹⁷ et 10¹⁹ atomes/cm⁻³, avec une diffusion bien plus profonde, de profondeur typiquement variant de 5 à 90 microns lorsque les profondeurs des première (5) et quatrième (8) zones varient de respectivement de 0,5 à 5 microns et de 0,2 à 2 microns
les caractéristiques dimensionnelles et les caractéristiques de dopage de cette barre de semi-conducteur (12) étant choisies pour que :
. la caractéristique courant-tension de ce composant soit, en direct, celle (C1) d'une diode pour toutes les valeurs d'intensité du courant n'excédant pas une valeur limite IL ; et
. pour cette valeur limite IL, cette caractéristique présente un palier (C2), le courant restant alors sensiblement constant et égal à celle valeur limite IL tandis que la tension aux bornes de ce composant croît jusqu'à une valeur limite de tension VBR qui correspond à la tension de claquage du composant.

2. Composant limiteur selon la revendication 1, caractérisé en ce que les caractéristiques de dopage respectives de ces quatre zones successives N,P,N,P sont telles que, pour les faibles niveaux de courant, la somme des gains en courant du transistor bipolaire PNP (13) formé par les trois premières zones (5,6,7) et du transistor bipolaire NPN (14) formé par les trois dernières zones (6,7,8) soit égale à 1.

3. Procédé de réalisation d'un composant limiteur (1) selon la revendication 1 ou la revendication 2, caractérisé en ce que l'on utilise, pour la réalisation desdites première (5) et quatrième (8) zones, un procédé de dopage par implantation et diffusion avec des doses d'implantation comprises entre 7.10¹⁴ cm⁻² et 7.10¹⁵ cm⁻² et des temps de diffusion compris entre 20 et 70 minutes en ambiance neutre ou oxydante.

4. Procédé de réalisation d'un composant limiteur selon la revendication 1 ou la revendication 2, caractérisé en ce que l'on utilise, pour la réalisation desdites quatrième (8) et première zones (5), un procédé de dopage par diffusion en phase solide, liquide ou gazeuse pour obtenir des niveaux de dopage compris entre 5.10¹⁹ cm⁻³ et 5.10²⁰ cm⁻³ pour la quatrième zone (8) dopée N, et entre 8.10¹⁸ cm⁻³ et 8.10¹⁹ cm⁻³ pour la première zone (5) dopée P, avec des profondeurs de jonctions allant de 0,2 à 2 microns pour la quatrième zone (8) et de 0,5 à 5 microns pour la première zone (5).

## Patentansprüche

1. Strombegrenzungsanordnung, bestehend aus einer Halbleiter-Scheibe oder -Stange (12) mit drei Grenzflächen (9, 10, 11), wobei dieser Halbleiter zwischen zwei Elektroden (3, 4) eingeschlossen ist, von denen eine Elektrode oder Anode (3), Eingang des zu begrenzenden Stromes, und eine Elektrode oder Kathode (4), Ausgang dieses Stromes ist und nacheinander zwischen dieser Anode und dieser Kathode
- eine erste, P-dotierte Zone (5),
- eine zweite, N-dotierte Zone (6),
- eine dritte, P-dotierte Zone (7),
- eine vierte und letzte, N-dotierte Zone (8)
aufweist, in der
die Halbleiter-Scheibe (12), z.B. zur Herstellung dieser Anordnung benutztes Silizium, eine Länge (oder "Dicke") zwischen 160 und 700 Mikrometer aufweist und eine Basis-Dotierung, die zwischen 10¹³ cm⁻³ und 10¹⁵ cm⁻³ liegt,
besagte erste Zone (5) mit mehr als 10¹⁸ Atomen/cm⁻³ P-dotiert ist, mit Diffusion in relativ geringe Tiefe, wobei die Tiefe typischerweise zwischen 0,5 und 5 Mikrometern liegt,
besagte vierte Zone (8) mit mehr als 10¹⁸ Atomen/cm⁻³ N-dotiert ist, auch sie mit Diffusion in relativ geringe Tiefe, wobei die Tiefe die typischerweise zwischen 0,2 und 2 Mikrometern liegt,
besagte zweite (6) und dritte (7) Zone entweder mit mindestens 10¹⁵ Atomen/cm⁻³ N-dotiert und mit zwischen 10¹⁷ und 10¹⁹ Atomen/cm⁻³ P-dotiert ist, mit Diffusion in größere Tiefe, wobei die Tiefe typischerweise zwischen 5 bis 90 Mikrometern variiert, wenn die Tiefen der ersten (5) und vierten (8) Zone von 0,5 bis 5 Mikrometer bzw. von 0,2 bis 2 Mikrometer variieren,
wobei die Dimensions-Eigenschaften und die Dotierungs-Eigenschaften dieser Halbleiterstange (12) so gewählt sind, dass
die Strom-Spannungs-Charakteristik dieser Anordnung unmittelbar die (C1) einer Diode für alle Werte der Stromstärke ist und nicht einen begrenzten Wert IL übersteigt; und für diesen begrenzten Wert IL diese Eigenschaft eine Stufe (C2) darstellt, wobei der Strom dann deutlich konstant und gleichmäßig auf diesem begrenzten Wert IL bleibt, während die Klemmpannung dieser Anordnung bis zu einem Grenzwert VBR ansteigt, der der Durchbruchsspannung der Anordnung entspricht.

2. Begrenzungsanordnung nach Anspruch 1, **dadurch gekennzeichnet**, dass die Dotierungs-Eigenschaften bezüglich der vier aufeinanderfolgenden Zonen N-P-N-P so sind, dass, für die schwachen Stromstärken, die Summe der Stromausbeute des durch die drei ersten Zonen (5,6,7) gebildeten bipolaren Transistors PNP (13) und des durch die drei letzten Zonen (6,7,8) gebildeten bipolaren Transistors NPN (14), gleich 1 ist.

3. Verfahren zur Herstellung einer Begrenzungsanordnung (1) gemäss Anspruch 1 oder Anspruch 2, **dadurch gekennzeichnet** dass man zur Herstellung der ersten (5) und vierten (8) Zone ein Dotierungsverfahren durch Implantierung und Diffusion anwendet, mit Implantierungsmengen, die zwischen 7.10¹⁴ cm⁻² und 7.10¹⁵ cm⁻² liegen und Streuungszeiten zwischen 20 und 70 Minuten in einer neutralen oder oxidierenden Umgebung.

4. Verfahren zur Herstellung einer Begrenzungsanordnung gemäss Anspruch 1 oder Anspruch 2, **dadurch gekennzeichnet**, dass man für die Herstellung der vierten (8) und ersten Zone (5) ein Dotierungsverfahren durch Diffusion aus fester, flüssiger oder gasförmiger Phase anwendet, um Dotierungen zu erhalten, die für die vierte, P-dotierte Zone (8) zwischen 5.10¹⁹ cm⁻³ und 5.10²⁰ cm⁻³ und für die erste, P-dotierte Zone (5) zwischen 8.10¹⁸ cm⁻³ und 8.10¹⁹ cm⁻³ liegen, mit Tiefen der Übergangszonen, die von 0,2 bis 2 Mikrometer für die vierte Zone (8) und von 0,5 bis 5 Mikrometer für die ersten Zone (5) reichen.

## Claims

1. A current limiter component consisting of a semiconductor wafer or bar (12) with three junctions (9, 10, 11), said semiconductor being bounded by two electrodes (3, 4), one of which is an inlet electrode, or anode (3), for the current to be limited and the other of which is an outlet electrode, or cathode (4), for this current, and comprising in succession, between said anode and said cathode:
- a first, P-doped zone (5),
- a second, N-doped zone (6),
- a third, P-doped zone (7),
- a fourth and last, N-doped zone (8),
wherein
the semiconductor wafer (12), of silicon for example, used in the production of this component exhibits a length (or "thickness") of between 160 and 700 microns and base doping of between 10¹³cm⁻³ and 10¹⁵cm⁻³,
said first zone (5) is P-doped at a rate of more than 10¹⁸ atoms/cm⁻³ with relatively shallow diffusion, the depth typically being between 0.5 and 5 microns,
said fourth zone (8) is N-doped at a rate of more than 10¹⁸ atoms/cm⁻³ with diffusion which is again relatively shallow, the depth typically being between 0.2 and 2 microns,
said second (6) and third (7) zones are respectively N-doped at a rate of less than 10¹⁵ atoms/cm⁻³ and P-doped at a rate of between 10¹⁷ and 10¹⁹ atoms/cm⁻³, with much deeper diffusion, the depth ranging typically from 5 to 90 microns when the depths of the first (5) and fourth (8) zones range respectively from 0.5 to 5 microns and 0.2 to 2 microns,
the dimensional characteristics and the doping characteristics of this semiconductor bar (12) being selected such that:
. the current-voltage characteristic of this component is, in the forward direction, that (C1) of a diode for all the current intensity values not exceeding a limit value IL; and
. for this limit value IL, this characteristic comprises a plateau (C2), the current remaining substantially constant at that point and equal to said limit value IL while the voltage at the terminals of this component increases to a voltage limit value VBR which corresponds to the breakdown voltage of the component.

2. A limiter component according to claim 1,
characterised in that the respective doping characteristics of these four successive N, P, N, P zones are such that, for low levels of current, the sum of the current gains of the PNP bipolar transistor (13) formed of the first three zones (5, 6, 7) and of the NPN bipolar transistor (14) formed of the last three zones (6, 7, 8) is equal to 1.

3. A process for producing a limiter component (1) according to claim 1 or claim 2, characterised in that an implantation and diffusion doping process is used to produce said first (5) and fourth (8) zones, the implantation doses being between 7·10¹⁴ cm⁻² and 7.10¹⁵ cm⁻² and the diffusion times being between 20 and 70 minutes in an inert or oxidising atmosphere.

4. A process for producing a limiter component according to claim 1 or claim 2, characterised in that a solid, liquid or gaseous phase diffusion doping process is used to produce said fourth (8) and first (5) zones, so as to obtain doping levels of between 5·10¹⁹ cm⁻³ and 5·10²⁰ cm⁻³ for the fourth, N-doped zone (8) and between 8·10¹⁸ cm⁻³ and 8·10¹⁹ cm⁻³ for the first, P-doped zone (5), with junction depths ranging from 0.2 to 2 microns for the fourth zone (8) and from 0.5 to 5 microns for the first zone (5).
